# EUROPÄISCHE PATENTSCHRIFT

(11) **EP 0 223 770 B1**
(45) Veröffentlichungstag und Bekanntmachung des Hinweises auf die Patenterteilung: **25.08.1993**
(21) Anmeldenummer: 86890314.7
(22) Anmeldetag: 13.11.1986
(51) Int. Cl.: G03F 1/00

(54) **Anordnung zum Vermeiden von plastischen Verformungen einer Maskenfolie**
Means for avoiding plastic deformation of a maskfoil
Dispositif pour éviter des déformations plastiques d'une feuille de masquage

(30) Priorität: 13.11.1985 AT 3310/85
(43) Veröffentlichungstag der Anmeldung: 27.05.1987
(73) Patentinhaber: IMS Ionen Mikrofabrikations Systeme Gesellschaft m.b.H., A-1020 Wien (AT); Österreichische Investitionskredit Aktiengesellschaft, 1013 Wien (AT)
(72) Erfinder: Löschner, Hans, Dr., A-1190 Wien (AT); Stengl, Gerhard, Dr., A-9500 Villach Kärnten (AT)
(74) Vertreter: Casati, Wilhelm, Dipl.-Ing.

(56) Entgegenhaltungen:
- AT-A- 383 438
- GB-A- 2 067 785
- PATENT ABSTRACTS OF JAPAN, Band 4, Nr. 82 (P-15)[564], 13. Juni 1980 & JP-A-55 46 758 (CHO LI GIJUTSU KENKYU KUMIAI) 02-04-1980

## Beschreibung

Die Erfindung betrifft eine Anordnung zum Vermeiden von plastischen Verformungen bzw. des Zerreißens einer Maskenfolie, die an mindestens einer Stelle für ein Abbildungsmedium, z.B. Ionenstrahlen, durchlässig ist und in einem aus einem Oberteil und einem Basisteil gebildeten Halterahmen, mit ihrem Randbereich zwischen diesen Rahmenteilen liegend, mechanisch geklemmt ist, bei Teilchen- oder Strahlenbelastung, wobei durch Temperaturänderung aufgrund unterschiedlicher thermischer Ausdehnungskoeffizienten von Halterahmen und Maskenfolie die Maskenfolie im Halterahmen unter Zugspannung setzbar ist, in welchem Zustand die Maskenfolie planar ist.

Durch die GB-A 20 67 785 wurde eine freitragende Maske für die Verwendung zur Strukturierung von Substraten, insbesondere von Halbleitersubstraten, durch Strahlung oder durch einen Teilchenstrom (Abbildungsmedium), bestehend aus einer an einem Rahmen befestigten Maskenfolie bekannt, in der mindestens ein gegenüber dem Abbildungsmedium durchlässiges Gebiet vorgesehen ist, wobei der Rahmen und die Maskenfolie aus Werkstoffen mit unerschiedlichen thermischen Ausdehnungskoeffizienten bestehen, wobei die Maskenfolie bei der Temperatur, die sie beim Einsatz der Maske annimmt und die gegebenenfalls über der Zimmertemperatur liegt, durch vom Rahmen auf die Maskenfolie ausgeübte Kräfte thermisch vorgespannt ist, wobei diese Kräfte daraus resultieren, daß der thermische Ausdehnungskoeffizient der vorzugsweise aus Metall, insbesondere, Nickel, bestehenden Maskenfolie niedriger ist als der thermische Ausdehnungskoeffizient des vorzugsweise aus Metall, insbesondere Aluminium, bestehenden Rahmens, und die Temperatur des Rahmens während des Einsatzes der Maske höher gehalten wird als während des Zusammenfügens der Maske. Masken dieser Art bereiten bei der Herstellung insoferne Schwierigkeiten, als ein Kühlen erforderlich ist, wozu im Regelfall auch Stickstoff verwendet wird. Dabei ist die Temperatur, auf welche gekühlt wird, gleich der Siedetemperatur von Stickstoff. Das Kältemittel muß dabei gesondert beschafft und gelagert werden. Die Temperatur ist entsprechend tief und der Abstand zur Arbeitstemperatur demgemäß groß, sodaß der Spannungsunterschied zwischen der Aufbewahrungs- bzw. Arbeitstemperatur und der Temperatur, bei der die Maske in den Rahmen geklemmt wird (Einspanntemperatur), bedeutend ist.

Es ist weiters bekannt, eine metallische Maskenfolie im rohrförmigen Glaskörper einer Kathodenstrahlröhre zu befestigen (GB-PS 11 63 495). Da Glas einen kleineren thermischen Ausdehnungskoeffizienten als das Metall der Maskenfolie besitzt, kann - soferne die Maskenfolie im erwärmten Zustand im Glaswerkstoff verankert wird - ein Spannen der Maskenfolie erreicht werden, wenn abgekühlt wird. Die Verankerung muß gemäß GB-PS 1 163 495 bei hoher Temperatur erfolgen, um ein Schmelzen des Glaskörpers zu erreichen. Bei dem folgenden Abkühlen auf Raumtemperatur wird die Metallmaskenfolie derart stark gespannt, daß die Elastizitätsgrenze des Folienmaterials überschritten wird, wodurch plastische Änderungen der Folie entstehen.

Der Erfindung liegt nun die Aufgabe zugrunde, eine Maske der eingangs erwähnten Art so zu gestalten, daß die Maskenfolie auch nach dem Einspannen eine Spannung aufweist, die im Elastizitätsbereich liegt und daß sie unter den Temperaturbelastungen, welchen sie bei ihrem Einsatz unterliegt, ebenflächig bleibt, um eine strukturtreue Abbildung des durchlässigen Bereiches auf das Substrat sicherzustellen und ein Zerreißen der Folie bei zu starker Strahlenbelastung zu vermeiden.

Erreicht wird dies, wenn gemäß der Erfindung bei einer Anordnung der eingangs erwähnten Art, der thermische Ausdehnungskoeffizient der, insbes. aus Metall, z.B. Nickel, bestehenden Maskenfolie größer ist als der thermische Ausdehnungskoeffizient des, bevorzugt ebenfalls aus Metall, insbesondere Invarstahl, bestehenden Halterahmens, so daß durch Abkühlen der aus Maskenfolie und Halterahmen bestehenden Anordnung die Maskenfolie über den Halterahmen vorgespannt wird und bei zu starker Strahlenbelastung die Maskenfolie zum Durchhängen kommt und nach Abkühlung wieder in den planaren Zustand zurückkehrt. Durch die erfindungsgemäß vorgesehene Ausbildung der Anordnung wird sichergestellt, daß auch unter permanenter Teilchen- oder Strahlenbelastung, wie sie beim Einsatz der Maske auftritt, die Ebenflächigkeit der Maske sichergestellt werden kann, wobei im Unterschied zu ebenfalls bekannten Masken, bei welchen eine Folie aus Nickel in einem Glasrahmen gehaltert ist, eine größere Flexibilität in der Auswahl der Materialien für die Maskenfolie und den Halterahmen gegeben ist. Die Gefahr des Reißens der Maskenfolie ist sicher vermieden, da im Falle hoher Teilchen- oder Strahlenbelastung die Maskenfolie in der erfindungsgemäßen Anordnung zum Durchhängen kommt, nach Abkühlung jedoch wieder in den planen Zustand zurückkehrt und weiter verwendet werden kann. Durch die Strahlenbelastung beim Einsatz der Maske wird bei erfindungsgemäßer Anordnung lediglich die thermische Vorspannung vermindert. Für den Anwendungsbereich, in dem die Maske vorgesehen ist, z.B. in einem Ionenprojektor, kommt es - obwohl mit steigender Temperatur die Vorspannung der Maske abnimmt - bei erfindungsgemäßer Anordnung zu keiner Änderung in der Lage der Strukturöffnungen bzw. der Konturen des durchlässigen Bereiches in der Maskenfolie.

Die erfindungsgemäße Anordnung kann in einfacher Weise nach einem Verfahren hergestellt werden, bei dem die Maskenfolie gemeinsam mit dem Halterahmen, insbesondere in einem Flüssigkeitsbad, auf die Klemmtemperatur gebracht wird, nach deren Erreichen die Maske im Halterahmen festgeklemmt wird, worauf die Maskenfolie durch Ändern der Temperatur unter Zugspannung im elastischen Bereich gesetzt wird, wenn hiebei in erfindungsgemäßer Weise durch Erwärmen auf eine über der Raumtemperatur liegende Temperatur, z.B. aus dem Temperaturbereich von 50 - 100°C, die Maskenfolie gemeinsam mit dem Halterahmen auf die Klemmtemperatur gebracht wird und wenn nach dem Klemmen die Maske bis auf die Aufbewahrungstemperatur, z.B. Raumtemperatur, abgekühlt wird. Die Erwärmung der Maskenfolie bzw. des Halterahmens kann in Flüssigkeitsbädern, jedoch auch im Luftstrom oder im Strom eines anderen erhitzten Gases erfolgen.

In besonders bevorzugter Weise wird für den Fall, daß der Halterahmen und die Maskenfolie vor dem Festklemmen der Folie im Halterahmen auf die gleiche Temperatur gebracht werden, die Erwärmung in einem Flüssigkeitsbad ausgeführt.

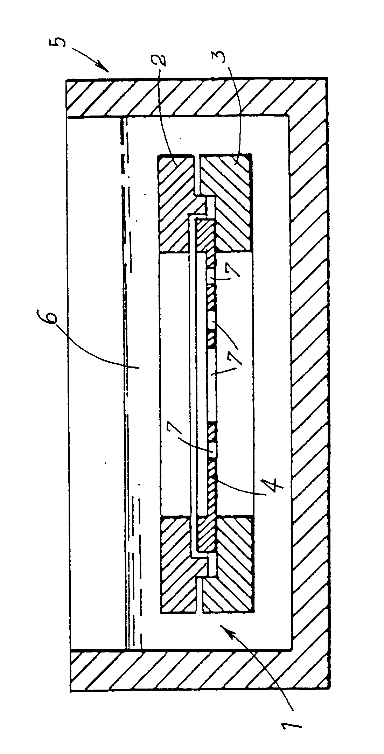

Die Erfindung wird nachstehend anhand eines in der Zeichnung im Schnitt dargestellten Ausführungsbeispieles näher erläutert.

In der Zeichnung ist mit 1 ein Halterahmen für eine Maskenfolie 4 bezeichnet. Die Maskenfolie 4 kann zwecks leichterer Handhabung einen verstärkten Randbereich, wie in der Zeichnung beispielsweise dargestellt, aufweisen. Der Halterahmen besteht aus einem Oberteil 2 und einem Basisteil 3. Die Maskenfolie 4 wird zwischen dem Basisteil 3 und dem Oberteil 2 eingeklemmt. In der Zeichnung ist dabei der Oberteil 2 in vom Basisteil 3 abgehobener Stellung dargestellt. Die Maskenfolie 4 besitzt Bereiche 7, in welchen sie für ein Abbildungsmedium, z.B. Ionenstrahlen, Elektronenstrahlen u.dgl., durchlässig ist. Als Maskenfolie 4 kann eine Nickelfolie Verwendung finden. Die Stärke der Maskenfolie 4 beträgt typisch einige µm, z.B. 3 bis 5 µm, kann jedoch auch darunter liegen (z.B. 0,5 µm betragen). Die Stärke der Maskenfolie kann dabei an einzelnen Stellen auch größer oder kleiner als der vorgenannte Wert sein. Die Maskenfolie 4 kann 5 cm x 5 cm groß sein.

Im Betrieb, d.h. beim Abbilden der für das Abbildungsmedium durchlässigen Bereiche 7 auf ein Substrat wird die Maskenfolie 4 bevorzugt senkrecht zu ihrer Oberfläche belichtet, z.B. mittels eines Ionenstrahles oder eines Elektronenstrahles. Dabei wird die Maskenfolie einer beträchtlichen thermischen Belastung ausgesetzt, wie sie z.B. bei einer Belastung der Maskenfolie mit 10 KeV Ionen und mit einer Ionenstromdichte von 10 µA/cm² entsteht. Für die Genauigkeit der Strukturübertragung von der Maskenfolie auf das Substrat ist es dabei wesentlich, daß die Maskenfolie 4 während der Durchstrahlung plan bleibt. Dazu ist die Maskenfolie 4 im Halterahmen 1 vorgespannt, wobei die Vorspannung der Maskenfolie 4 auch im Betriebszustand noch vorhanden sein muß. Um die Vorspannung sicherzustellen, ist der thermische Ausdehnungskoeffizient der Maskenfolie 4 größer als der Ausdehnungskoeffizient des Halterahmens 1. Bei Abkühlen der Maskenfolie 1 steigt die Spannung in der Maskenfolie. Bei der Aufbewahrungstemperatur der aus Halterahmen 1 und eingespannter Maskenfolie 4 bestehender Maske liegt die Spannung der Maskenfolie 4 im elastischen Bereich. Eine bleibende Verformung der Maskenfolie 4 ist dadurch hintangehalten. Für den Rahmen kann bevorzugt von Glas verschiedenes Material, z.B. INVAR-Stahl, verwendet werden.

Um der Maskenfolie 4 die gewünschte Vorspannung aufzuprägen, kann so vorgegangen werden, daß die Maskenfolie 4 gemeinsam mit den beiden Teilen des Halterahmens 1 auf eine über der Raumtemperatur liegende Temperatur, von z.B. 60°, gebracht wird. Dies kann dadurch erfolgen, daß - wie dies die Zeichnungsfigur veranschaulicht - der Basisteil 3, der Oberteil 2 und die Maskenfolie 4 in ein die gewünschte Temperatur aufweisendes Flüssigkeitsbad 6 in einem Behälter 5 gebracht werden und dort solange verbleiben, bis die Einsatzteile die Badtemperatur erreicht haben. Sodann werden, unter Zwischenlage der Ränder der Maskenfolie 4, Basisteil 3 und Oberteil 2 zusammengeklemmt, so daß die Maskenfolie im Rahmen festgeklemmt ist. Durch Kühlen der Maske auf die Aufbewahrungstemperatur, z.B. Raumtemperatur, wird dann die Maskenfolie 4 unter Spannung gesetzt, da sie beim Abkühlen stärker schrumpft als der Halterahmen 1. Die maximal mögliche Einsatztemperatur der Maskenfolie unter Strahlenbelastung, ist der Einspanntemperatur angenähert, wenn der Halterahmen aus einem Material mit sehr geringem thermischen Ausdehnungskoeffizienten gefertigt wird.

## Patentansprüche

1. Anordnung zum Vermeiden von plastischen Verformungen bzw. des Zerreißens einer Maskenfolie, die an mindestens einer Stelle für ein Abbildungsmedium, z.B. Ionenstrahlen, durchlässig und in einem aus einem Oberteil und einem Basisteil gebildeten Halterahmen, mit ihrem Randbereich zwischen diesen Rahmenteilen liegend, mechanisch geklemmt ist, bei Teilchen- oder Strahlenbelastung, wobei durch Temperaturänderung aufgrund unterschiedlicher thermischer Ausdehnungskoeffizienten von Halterahmen und Maskenfolie die Maskenfolie im Halterahmen unter Zugspannung setzbar ist, in welchem Zustand die Maskenfolie planar ist, dadurch gekennzeichnet, daß der thermische Ausdehnungskoeffizient der, insbes. aus Metall, z.B. Nickel, bestehenden Maskenfolie (4) größer ist als der thermische Ausdehnungskoeffizient des, bevorzugt ebenfalls aus Metall, insbesondere Invarstahl, bestehenden Halterahmens (1), so daß durch Abkühlen der aus Maskenfolie und Halterahmen bestehenden Anordnung die Maskenfolie (4) über den Halterahmen (1) vorgespannt wird und bei zu starker Strahlenbelastung die Maskenfolie zum Durchhängen kommt und nach Abkühlung wieder in den planaren Zustand zurückkehrt.

2. Verfahren zur Herstellung einer Anordnung zum Vermeiden des Zerreißens einer Maskenfolie unter Teilchen- oder Strahlenbelastung, nach Anspruch 1, bei dem die Maskenfolie gemeinsam mit dem Halterahmen, insbesondere in einem Flüssigkeitsbad auf die Klemmtemperatur gebracht wird, nach deren Erreichen die Maskenfolie im Halterahmen festgeklemmt wird, worauf die Maskenfolie durch Ändern der Temperatur unter Zugspannung im elastischen Bereich gesetzt wird, dadurch gekennzeichnet, daß durch Erwärmen auf eine über der Raumtemperatur liegende Temperatur, z.B. aus dem Temperaturbereich von 50 - 100°C, die Maskenfolie gemeinsam mit dem Halterahmen auf die Klemmtemperatur gebracht wird, und daß nach dem Klemmen, die Maske bis auf die Aufbewahrungstemperatur, z.B. Raumtemperatur, abgekühlt wird.

## Claims

1. Arrangement for preventing plastic deformation or tearing of a mask film when subjected to particles or beams which is permeable at at least one position to an imaging medium, e.g. ion beams, and is mechanically clamped in a support frame, which comprises an upper portion and a base portion, with its edge region lying between these frame portions, whereby the mask film may be placed in the support frame under tension as a result of changes in temperature due to differing coefficients of thermal expansion of the support frame and mask film, in which state the mask film is planar, characterised in that the coefficient of thermal expansion of the mask film (4), which consists of, in particular metal, e.g. nickel, is larger than the coefficient of thermal expansion of the support frame (1) which preferably consists also of metal, particularly Invar steel, so that by cooling the arrangement comprising the mask film and support frame the mask film (4) is prestretched over the support frame (1) and on excessive subjection to beams the mask film sags and after cooling returns to the planar state again.

2. Method of manufacturing an arrangement for preventing tearing of a mask film when subjected to particles or beams as claimed in claim 1 in which the mask film is brought together with the support frame to the clamping temperature, particularly in a liquid bath, after reaching which the mask film is clamped in the support frame, whereafter the mask film is placed under tension in the elastic range by changing the temperature, characterised in that by warming to a temperature above room temperature, e.g. out of the temperature range of 50-100°C, the mask film is brought together with a support frame to the clamping temperature and that after clamping the mask is cooled to the storage temperature, e.g. room temperature.

## Revendications

1. Dispositif pour éviter les déformations plastiques ou le déchirement d'une feuille de masquage, pincée mécaniquement en au moins un endroit, pour un milieu de représentation d'image, par exemple une irradiation ionique, ladite feuille étant transparente et dans un cadre de fixation constitué par une partie supérieure et une partie de base, ladite feuille reposant par sa zone de bordure entre lesdites parties du cadre, et étant exposée à des particules ou à des rayons, exposition au cours de laquelle, suite à une variation de la température, du fait de la différence entre les coefficients de dilatation thermiques du cadre de fixation et de la feuille de masquage, cette dernière est susceptible d'être exposée à une contrainte de traction dans le cadre de fixation, lui donnant un état plan, caractérisé en ce que le coefficient de dilatation thermique de la feuille de masquage (4), composée en particulier en métal, par exemple en nickel, est supérieur au coefficient de dilatation thermique du cadre de fixation (1), réalisé de préférence également en métal, en particulier en acier Invar, de sorte que par refroidissement du dispositif constitué par la feuille de masquage et du cadre de fixation, la feuille de masquage (4) est précontrainte sur le cadre de fixation (1), et qu'en cas de trop forte intensité de l'irradiation, la feuille de masquage devient lâche et revient à l'état plan après refroidissement.

2. Procédé de fabrication d'un dispositif pour éviter le déchirement d'une feuille de masquage, exposée à des particules ou à des rayons, selon la revendication 1, dans lequel la feuille de masquage est amenée à la température de pinçage, conjointement avec le cadre de fixation, en particulier dans un bain liquide, la feuille de masquage étant fixée par pinçage dans le cadre de fixation, une fois atteinte la température de pinçage, à la suite de quoi la feuille de masquage est amenée dans son domaine d'élasticité, sous une contrainte de traction, par modification de la température, caractérisé en ce que par chauffage à une température supérieure à la température ambiante, par exemple hors de la plage de température allant de 50 à 100°C, la feuille de masquage est amenée à la température de pinçage, conjointement avec le cadre de fixation, et en ce qu'après pinçage, le masque est refroidi, jusqu'à la température de stockage, par exemple la température ambiante.
